# EUROPÄISCHE PATENTSCHRIFT

(11) **EP 1 179 611 B1**
(45) Veröffentlichungstag und Bekanntmachung des Hinweises auf die Patenterteilung: **15.09.2004**
(21) Anmeldenummer: 01119538.5
(22) Anmeldetag: 11.09.1993
(51) Int. Cl.: C23C 14/56, H01L 21/00, C23C 14/04

(54) **Kammer für den Transport von Werkstücken**
Chamber for transport of substrates
Enceinte pour le transport des substrats

(30) Priorität: 06.10.1992 CH 311992; 11.03.1993 CH 75793
(43) Veröffentlichungstag der Anmeldung: 13.02.2002
(62) Teilanmeldung aus: 93114639.3
(73) Patentinhaber: Unaxis Balzers Aktiengesellschaft, 9496 Balzers (LI)
(72) Erfinder: Schertler, Roman, 6922 Wolfurt (AT)
(74) Vertreter: Troesch Scheidegger Werner AG

(56) Entgegenhaltungen:
- DD-A- 250 248
- US-A- 4 676 884
- PATENT ABSTRACTS OF JAPAN vol. 015, no. 167 (C-0827), 26. April 1991 (1991-04-26) & JP 03 036267 A (ULVAC CORP), 15. Februar 1991 (1991-02-15)

## Beschreibung

Die vorliegende Erfindung betrifft ein Verfahren zur Fertigung vakuumbehandelter Speicherplatten nach dem Oberbegriff von Anspruch 1 sowie eine Transportanordnung nach demjenigen von Anspruch 3.

Aus der DD 250 248 ist es bekannt, einen Probenträger aus ferromagnetischem Werkstoff unter einem Wafer aus nicht ferromagnetischem Material anzuordnen. Ein Elektromagnet wird über den Wafer in Position gebracht und nach Erregung dieses Magneten wird der ferromagnetische Probenträger mit dem Wafer angezogen. Durch Translation wird der Wafer mit dem Probenträger und dem Elektromagneten aus einer Schleusenkammer in einen Rezipienten bewegt. Dort, über einer Elektrode, wird der Elektromagnet abgeschaltet, so dass der Probenträger aus geringer Höhe abfällt und damit der nicht ferromagnetische Wafer direkt auf der Elektrode positioniert wird.

Aus der JP 03 036 267 ist es bekannt, während einer Substratbehandlung ein Maskierungsorgan dadurch am Substrat zu halten, dass an einem Werkstückträger Magnete vorgesehen sind. Wenn das Substrat freigegeben wird, wird das Maskierungsorgan entfernt und die Magnetkraft ist am Werkstückträger nicht mehr wirksam.

Es ist Aufgabe der vorliegenden Erfindung, ausgehend von einem Vorgehen letzterwähnter Art, Werkstücke während des Transportes hin zu einer Vakuumbehandlung auf möglichst einfache Art und Weise an einem Werkstückträgerteller zu halten. Dies wird durch das eingangs erwähnte Verfahren, ausgeführt nach dem Kennzeichen von Anspruch 1, bzw. durch Realisation der eingangs erwähnten Transportanordnung nach dem Kennzeichen von Anspruch 3 erreicht.

Die Erfindung wird anschliessend beispielsweise anhand von Figuren erläutert.

Es zeigen:
- Fig. 1: schematisch einen Längsschnitt durch eine bevorzugte Anlagenkonfiguration, woran die Erfindung unter ihren beiden Aspekten realisiert ist,
- Fig. 2: eine teilweise geschnittene Aufsicht auf eine Anlage gemäss Fig. 1,
- Fig. 2a: eine bevorzugte Ausführungsvariante einer an einer Kammer an der Anlage gemäss den Fig. 1 und 2 vorgesehenen Werkstückaufnahme,
- Fig. 3a - 3f: schematisch das Prinzip der Maskierung in bevorzugter Realisation,
- Fig. 4: den Uebergabebereich für Werkstücke mit Maskierungsorganen an einer Anlage gemäss den Fig. 1 bzw. 2 in einer weiteren Ausführungsform,
- Fig. 5: schematisch das Grundprinzip der Maskierung,
- Fig. 6: schematisch und teilweise geschnitten eine erfindungsgemässe Kammer, wie sie an der Anlage gemäss den Fig. 1 und 2 verwendet wird, zur Erläuterung des Grundprinzips der Erfindung unter einem ihrer Aspekte,
- Fig. 7: eine erfindungsgemässe Kammer analog zu der in Fig. 6 dargestellten als weitere Variante,
- Fig. 8: teilweise geschnitten, eine weitere Realisationsform der erfindüngsgemässen Kammerkombination, wie sie auch an der Anlage gemäss den Fig. 1 und 2 in abgewandelter Form realisiert ist,
- Fig. 9: prinzipiell die Kammerkombination gemäss Fig. 8 in einer weiteren Realisationsform,
- Fig. 10: in Aufsicht und teilweise geschnitten, eine erfindungsgemässe Kombination gemäss Fig. 9,
- Fig. 11: schematisch das Grundprinzip der Kombination gemäss den Fig. 8 bis 10 bzw. gemäss den Fig. 1 und 2,
- Fig. 12: ausgehend von einer Kombination nach Fig. 11 schematisch eine weitere Weiterentwicklungsvariante,
- Fig. 13: ausgehend von der Variante der Kammerkombination nach Fig. 12 eine Weiterentwicklung,
- Fig. 14: teilweise geschnitten eine weitere Realisationsform einer Kammer für eine erfindungsgemässe Kombination,
- Fig. 15: die Definition von graphischen Symbolen für verschiedene Kammertypen,
- Fig. 16: beispielsweise Anlagekonfigurationen bzw. Kammerkombinationen mit jeweils mindestens einer der Kammern, dem Prinzip der Kammern gemäss Fig. 1 und 2 folgend, modular aufgebaut,
- Fig. 17: schematisch die Aufsicht auf eine weitere bevorzugte Anlagekonfiguration, modular aufgebaut,
- Fig. 18: schematisch die Seitenansicht der Anlage in der Konfiguration nach Fig. 17.

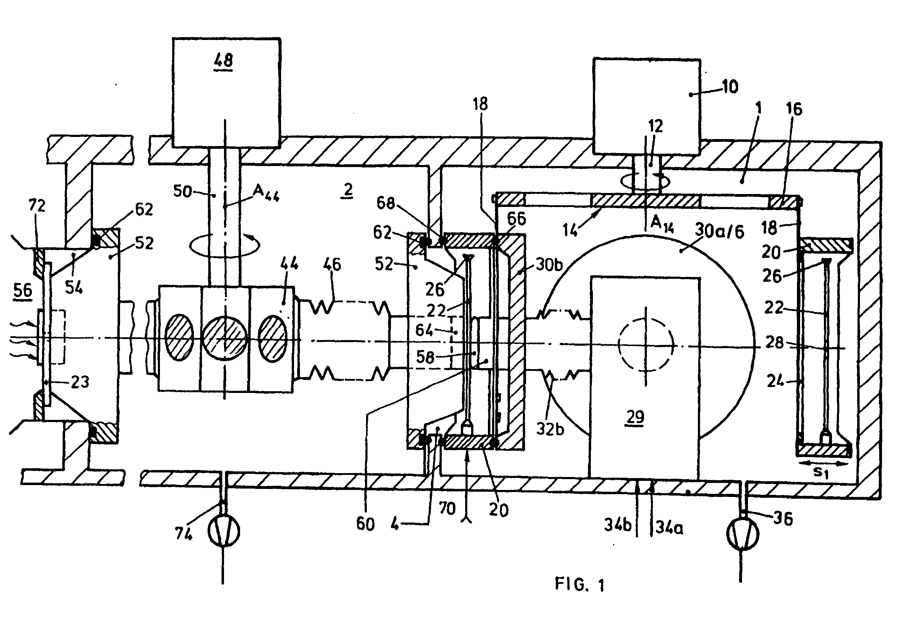

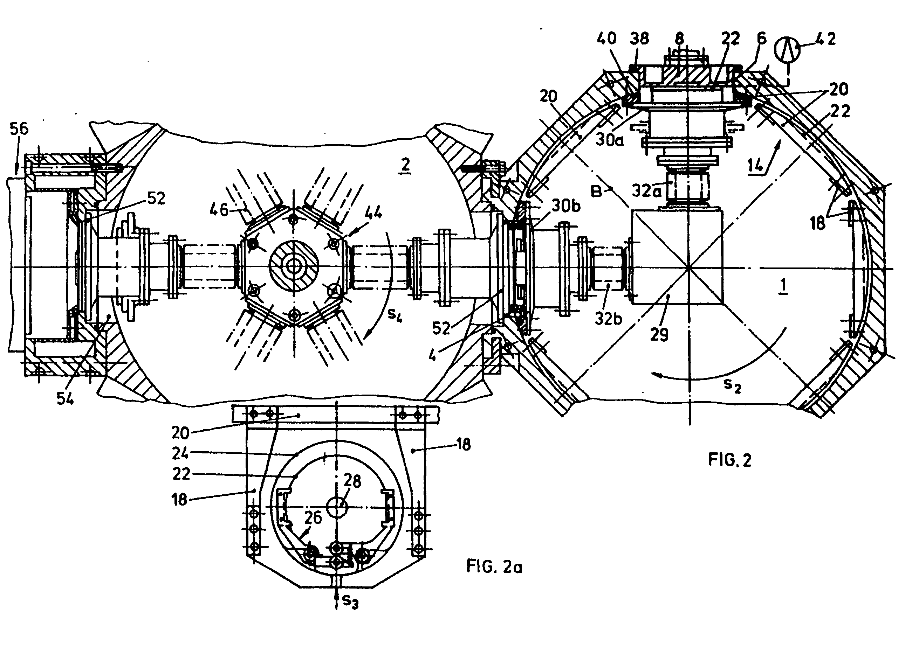

Annand der Fig. 1, 2, 2a soll vorerst eine neute bevorzugte Anlagenkonstellation beschrieben werden, welche das erfindungsgemässe Vorgehen umfasst. Fig. 1 ist weitergehend schematisiert als Fig. 2, aus Uebersichtsgründen. Es sind in den Fig. 1 bis 2a die gleichen Bezugszeichen verwendet.

Die Anlage umfasst eine erste Kammer 1 und eine zweite Kammer 2, welche über eine Verbindungsöffnung 4 miteinander kommunizieren. Die erste Kammer 1, als Pufferkammer ausgebildet, weist (Fig. 2) eine Zuspeise- bzw. Entnahmeöffnung 6 - eine Schleusenöffnung auf, die mit einem getrieben betätigten Zuführ- und Verschlussteller 8 dichtend verschliessbar ist. Zentral am Gehäuse der ersten Kammer 1 gelagert, ist ein Drehantrieb 10 vorgesehen, welcher über eine Antriebsachse 12 ein Karussell 14 antreibt Letzteres umfasst eine Uebertragerplatte 16, woran, über Blattfedern 18 (siehe auch Fig. 2a) Aufnahmen 20 für kreisscheibenförmige Werkstücke 22 angeordnet sind. Aufgrund der Blattfedernaufhängung sind die Aufnahmen 20, wie in Fig. 1 bei s₁ dargestellt, radial federnd ausbiegbar.

Die am Karussell 14 vorgesehenen acht Aufnahmen 20 sind im wesentlichen als Rahmen ausgebildet, wie insbesondere in Fig. 2a ersichtlich. Sie weisen, senkrecht zur Ausdehnungsfläche der Werkstücke 22 betrachtet, eine Durchgriffsöffnung 24 auf sowie, aus Uebersichtsgründen nur in Fig. 2a eingetragen, einen zangenähnlich wirkenden Fest haltemechanismus 26 für die Werkstücke 22 über der Durchgriffsöffnung 24. Aufgrund der randseitigen Anordnung (Fig. 2a) der Blattfedern 18 bleibt die Durchgriffsöffnung 24 frei.

Die Werkstücke, hier Speicherplatten, weisen eine Zentrumsöffnung 28 auf. Durch schrittweises Drehen des Karussells 14 werden Aufnahmen 20 sequentiell über die Oeffnungen 4 und 6 der Kammer 1 gedreht

Wie insbesondere auch in Fig. 2 ersichtlich, ist bezüglich der Achse A₁₄ des Karussells 14 in Kammer 1, dem Uebertrager 16 gegenüberliegend, ein Lasersockel 29 am Gehäuse der Kammer 1 starr montiert, woran, ausgerichtet auf die hier beispielsweise vorgesehenen zwei Oeffnungen 4 und 6, entsprechend, zwei unabhängig voneinander radial aus- und einschiebbare Teller 30a und 30b angeordnet sind. Die Antriebsorgane für die Teller 30a und 30b sind vakuumtechnisch über Bälge 32a, b abgedichtet bzw. abgekapselt. Pneumatische Steuerleitungen 34a bzw. b sind, wie in Fig. 1 schematisch dargestellt, in den Block 29 geführt. Wie mit 36 weiter schematisch in Fig. 1 dargestellt, weist die Kammer 1 einen Pumpanschluss 36 zu deren Konditionierung auf, gegebenenfalls auch Gasanschlüsse.

Durch das an der Kammer 1 realisierte Prinzip des Karussells mit einer Vielzahl von Aufnahmen 20 für Werkstücke und den radial wirkenden Tellern 30, wird, wie ersichtlich, erreicht, dass eine höhere Anzahl Werkstücke in dieser Kammer enthalten ist, als momentan durch die vorgesehenen Oeffnungen gehandhabt wird, was den grossen Vorteil mit sich bringt, dass die momentan bezüglich der erwähnten Oeffnungen nicht gehandhabten Werkstücke in dieser Kammer konditioniert, insbesondere ausgegast werden können. Dies kann durch Beheizen unterstützt werden oder andere bekannte Vorbehandlungen.

Im weiteren ist ein Vorteil darin zu erblicken, dass die Handhabung der Werkstücke bezüglich der erwähnten Oeffnungen in derselben Ebene erfolgt, in welcher mittels des Karussells die Werkstücke in Kammer 1 gedreht werden. Mithin eröffnet sich damit die Möglichkeit, eine Gesamtanlage mit der Kammer 1 und an ihren Oeffnungen angeordneten weiteren Kammern, seien dies weitere Transport- bzw. Verteilkammern oder Bearbeitungskammern oder Schleusenkammern, modular, kompakt auch radial, damit erwünschtenfalls flach aufzubauen.

Selbstverständlich können an der Kammer 1, jetzt für sich betrachtet, mehr als zwei Oeffnungen vorgesehen und durch entsprechend angeordnete Teller 30 radial bedient werden. Dabei bleibtdie Aufbaueinfachheit erhalten, indem das Karussell sehr einfach antreibbar ist und die radialen Handhabungsbewegungen von einem stationären Zentrum aus angesteuert werden können, womit auch diese Ansteuerung wesentlich einfacher ist als wenn Drehbewegung und Axialbewegung gekoppelt werden. Grundsätzlich ist es aber, unter Beibehalt dieser einfachen Bauweise, durchaus möglich, den Sokkel 29 mit den Tellern 30 um Achse A₁₄ getrieben, aber unabhängig vom Karussell 14 zu drehen. Damit können mit weniger Tellern 30 mehr Oeffnungen bedient werden. Dies insbesondere dann, wenn die Oeffnungen nicht dicht verschlossen werden müssen, wie z.B., wenn die Dichtung mittels Diffusionsspaltdichtungen für eine betrachtete Anwendung ausreicht.

Bei der hier dargestellten Ausführung wirkt der Oeffnungsbereich an der Oeffnung 6 als eigentliche Einund Auslassschleuse für Werkstücke, während die Kammer 1 an sich der Konditionierung aus der Atmosphäre eingebrachter Werkstücke dient, bevor sie durch Oeffnung 4 in noch zu beschreibender Art und Weise hin gegen eine Bearbeitungsstation gefördert werden.

Es sei nun an der spezifisch dargestellten Konfiguration der Kammer 1 die Funktion der Werkstückzu- bzw. Wegführung durch die als eigentliche Schleuse ausgebildete Oeffnung 6 betrachtet.

Durch Drehung des Karussells 14 in der mit s₂ in Fig. 2 eingetragenen Richtung wird bei rückgeholtem Teller 30a und selbstverständlich, über Dichtungen 38, dichtend verschlossenem Zuführ/Verschliessteller 8, eine Aufnahme 20, z.B. mit fertig bearbeitetem Werkstück, in den Oeffnungsbereich gedreht. Darnach wird mit dem Teller 30a, gegen die Wirkung der Federn 18, die betrachtete Aufnahme 20 mit Dichtungen 40 dichtend an die Wandung der Kammer 1 gelegt, wobei nicht dargestellte Dichtungen zwischen Aufnahme 20 und Teller 30a die vakuumdichte Abschottung der Oeffnung 6 zur Kammer 1 sicherstellen.

Beispielsweise magnetisch, pneumatisch oder mechanisch wird das Werkstück 22, nach Lösen des Festhaltemechanismus 26 durch Wirkung eines Betätigungsstössels, wie er in Fig. 2a bei s₃ dargestellt ist, vom Zuführ/Verschliessteller 8 aus der Aufnahme 20 übernommen. Unter Beibehaltung des dichten Verschlusses von Teller 30a über Aufnahme 20 an der Wandung der Kammer 1 kann nun der Zuführ/Verschliessteller 8 abgehoben werden, das bearbeitete Werkstück wird von ihm entfernt und ein neu zu bearbeitendes eingelegt. Der Teller 8 wird mit dem neu zu bearbeitenden Werkstück wiederum dichtend verschlossen, es übernimmt der Festhaltemechanismus 26 an der nun freien Aufnahme 20 das neu zu bearbeitende Werkstück, worauf der Teller 30a in die in Fig. 2 gestrichelt dargestellte Rückholposition gefahren wird. Damit ist das Karussell frei, einen Takt in Richtung s₂ weiter zu drehen.

Wie gestrichelt bei 42 (Fig. 2) dargestellt, kann die Oeffnung 6 über einen Pumpanschluss mit einer Pumpe 42 verbunden sein, wenn höchste Reinheitsanforderungen an die Atmosphäre in der Kammer 1 gestellt werden. Angesichts des extrem kleinen Volumens des als Schleuse wirkenden Oeffnungsbereiches 6 vermag aber das Verdünnungsverhältnis, gegeben durch das Volumen im Oeffnungsbereich 6 zu Volumen der Kammer 1 auszureichen, um meistens eine genügende Reinheit der Atmosphäre in der Kammer 1 zu gewährleisten.

Wie bereits erwähnt wurde, kann der Teller 8 als Transportteller ausgebildet werden und Teil eines Transportmechanismus in einer weiteren an Oeffnung 6 angeflanschten Kammer sein oder es kann ein anders gearteter Transportmechanismus Werkstücke durch Oeffnung 6 dem Karussell 14 zuspeisen bzw. daraus entnehmen. Im weiteren ist es ohne weiteres möglich, beispielsweise in der Radialposition B, eine Entnahmeschleuse vorzusehen, beispielsweise gleich aufgebaut, wie die im Zusammenhang mit der Oeffnung 6 beschriebene und an zwei getrennten Bereichen die Werkstücke der Kammer 1 zuzuführen und ihr wieder zu entnehmen.

Wie bereits erwähnt wurde, können mehr als zwei Teller 30 vorgesehen sein, um eine entsprechende Anzahl in der Kammer 1 vorgesehener Oeffnungen zu bedienen, im Extremfall so viele, wie Aufnahmen 20 vorgesehen sind.

Wie aus Fig. 2 ersichtlich, ist der Transportweg für die Werkstücke von ihrer Eingabe in die Kammer 1 zu ihrer Ausgabe aus der Kammer 1 hin gegen eine Bearbeitungsstation wesentlich länger als der Transportweg von einer Bearbeitungsstation zurück in die Kammer 1 und von dort zur Ausgabe des Werkstückes aus der Kammer 1. Grundsätzlich wird dann, wenn Kammer 1, wie auch immer ausgebildet, als Konditionierungskammer für Werkstücke vor ihrer Bearbeitung ausgenützt wird, der Transportweg für Werkstücke von einer Aufnahmeöffnung zu einer Ausgabeöffnung für zu bearbeitende Werkstücke länger gewählt als der Transportweg für bearbeitete Werkstücke von einer diesbezüglichen Aufnahmeöffnung zu einer diesbezüglichen Ausgabeöffnung, seien nun Eingabe/Ausgabeöffnungen auch wie in Fig. 2 dargestellt, kombiniert, in Form beispielsweise von Ein/Auslassschleusen. Dadurch wird die Verweilzeit der Werkstücke in Kammer 1 als Vorkammer verlängert, während welcher die Werkstücke Wasserdampf und Gas abgeben können. Die Werkstücke werden somit für nachmalige Bearbeitungsschritte vorbereitet (konditioniert). Dies ist besonders bei Materialien wichtig, die eine grosse Gas- bzw. Wasserabsorption aufweisen, wie beispielsweise üblicherweise für Speicherplatten eingesetzte Kunststoffe. Eine zu starke Ausgasung der Werkstücke an den Prozessstationen ist deshalb nicht tolerierbar, weil dadurch die Beschichtung der Werkstücke unbrauchbar werden kann.

Es sei nun weiter die Kammer 2 und ihre Wechselwirkung mit Kammer 1 betrachtet.

In der Kammer 2 ist ein Transportstern 44 mit beispielsweise sechs Transportarmen 46 vorgesehen, welcher durch einen Antrieb 48, über Achse 50 drehend angetrieben wird. Endständig sind an den Armen 46 mit vakuumdicht gekapselten Antriebsorganen radial vor- und rücktreibbare Teller 52 angeordnet. Die Teller 52 sind über die Oeffnung 4 zu Kammer 1 einerseits, sowie zu einer oder mehreren zusätzlichen Oeffnung(en) 54 schwenkbar, an welchen, wie am dargestellten Beispiel, eine oder mehrere Bearbeitungsstation(en) angeordnet sein können und/oder weitere Transportkammern bzw. Schleusenkammern. Am dargestellten Beispiel ist eine Bearbeitungskammer 56 vorgesehen.

Es sei nun die Uebergabe von Kammer 1 nach Kammer 2 von Werkstücken betrachtet. Die Werkstücke müssen für ihre Oberflächenbearbeitung in einer Bearbeitungsposition stromab der Oeffnung 4, d.h. in Bewegungsrichtung der Werkstücke hinter der Oeffnung 4, an erwünschten Oberflächenbereichen abgedeckt werden. Im hier betrachteten Fall von Speicherplatten muss für die Bearbeitung sowohl ihr Zentrumsbereich um die Oeffnung 28 sowie ihr Peripheriebereich an mindestens einer der Bearbeitungsstationen abgedeckt werden.

In noch zu beschreibender Art und Weise wird die Zentralmaskierung durch ein lose zugeführtes Maskierungselement je zu bearbeitendes Werkstück sichergestellt, welches, wie beschrieben werden wird, vor Bearbeitung den Werkstücken appliziert und nach Bearbeitung davon wieder entfernt wird. Die Maskierungsorgane 58 welche, nach deren Bearbeitung an den auf den Tellern 52 rückgeführten Werkstücken appliziert sind, werden im Bereich der Oeffnung 4 von diesen bereits bearbeiteten Werkstücken weggenommen und einem neu auf einem der Teller 52 in der Kammer 2 aufgebrachten Werkstück appliziert, das darnach, durch Drehen des Transportsternes 44, in Bearbeitungsposition gebracht wird. Hierzu ist am drehfesten Teller 30b von Kammer 1 ein Elektromagnet zentral angeordnet.

In der beispielsweise in Fig. 2 dargestellten Drehrichtung s₄ werde ein scheibenförmiges Werkstück 22 der angesprochenen Art in die in Fig. 1 dargestellte Position gegenüber der Oeffnung 4 transportiert. Der entsprechende Teller 52 wird mit Dichtungen 62 dicht an die Umrandung der Oeffnung 4 angelegt. Das auf ihm reitende Werkstück 22, gehaltert durch ein Magnet 64, vorzugsweise ein Permanentmagnet, wird damit in die Oeffnung 4 eingeschoben. Während der Drehbewegu ng des Tellers 52 um Achse 50 bzw. A44 bleibt eine Aufnahme 20 ohne Werkstück, also eine leere Aufnahme 20, über Oeffnung 4 positioniert Der Teller 30b presst dabei diese leere Aufnahme 20 über Dichtungen 66 und Dichtungen 68 dicht auf die Kammer-1-seitige Umrandung von Oeffnung 4, so dass während der Drehbewegung des Transportsternes 44 die beiden Kammern 1 und 2 dichtend, gegebenenfalls vakuumdicht, getrennt sind.

Wenn nun seinerseits der Teller 52 in Position gebracht, mit den Dichtungen 62 diese Trennung seitens Kammer 2 gewährleistet, wird der Elektromagnet 60 am Teller 30b aktiviert, das Maskierungsorgan 58, aus magnetischem Material, ergriffen und durch Rückzug des Tellers 30b ausser Eingriff mit dem Werkstück 22 und dem Teller 52 gebracht. Durch Betätigung eines Stössels, wie schematisch in Fig. 1 bei 70 dargestellt, ergreift der Festhaltemechanismus 26 gemäss Fig. 2a in der Aufnahme 20 das bearbeitete Werkstück 22. Nachdem der Teller 30b mit dem Maskierungsorgan 58 magnetisch daran gehaltert, rückgezogen ist, wird das Karussell 14 um einen Takt in Richtung s₂ weiter gedreht, wodurch eine nun mit einem nicht bearbeiteten Werkstück geladende Aufnahme 20 über die Oeffnung 4 gedreht wird. Das vormals behandelte, vom Maskierungsorgan befreite Werkstück liegt nun mit seiner zugeordneten Aufnahme 20 gemäss Fig. 2 in der Winkelposition B. Durch Vorschieben des Tellers 30b, weiterhin mit dem vormals aufgenommenen Maskierungsorgan 58, wird letzteres dem neu zugeführten Werkstück 22 appliziert. Mittels der Dichtungen 66 und 68 an der nun neu eingeschobenen Aufnahme 20 wird wiederum die Kammertrennung sichergestellt.

Der Elektromagnet 58 wird nun desaktiviert, womit der Magnet 64 das Maskierungsorgan 58 mit dem Werkstück an den Teller 52 zieht und hält Durch den dicht, vorzugsweise vakuumdicht (Balg), gebauten Stössel 70 wird hierzu der Festhaltemechanismus 26 gelöst.

Damit liegt nun das Werkstück maskiert auf dem Teller 52. Die Aufnahme 20 ist leer und bereit zur Aufnahme eines bearbeiteten Werkstückes im nächsten Zyklus. Der frisch geladende Teller 52 wird rückgeholt, die Kammertrennung ist durch Teller 30b und leere Aufnahme 20 sichergestellt Durch Drehen des Transportsternes 44 wird einerseits das eben geladene Werkstück gegen seine Bearbeitungsposition weiter gedreht, anderseits ein bereits bearbeitetes in Position gegenüber der leeren Aufnahme 20 gedreht Die Dichtung 68 ist z.B. an der Aufnahme 20 angeordnet und hat bei der hier dargestellten Anlage an der Oeffnung 6 schleusendichtende Aufgabe. Wie die Dichtung 68 können auch die Dichtungen 66 und/oder 62 als Diffusionsspaltdichtungen ausgebildet sein, wenn bei weniger heiklen Bearbeitungsprozessen eine vakuumdichte Trennung zwischen den Kammern 1 und 2 nicht erforderlich ist oder beispielsweise der Kammer 2 nachgeschaltete Bearbeitungs- und/oder Transportkammern für sich Abtrennorgane und Konditionierungsmittel aufweisen.

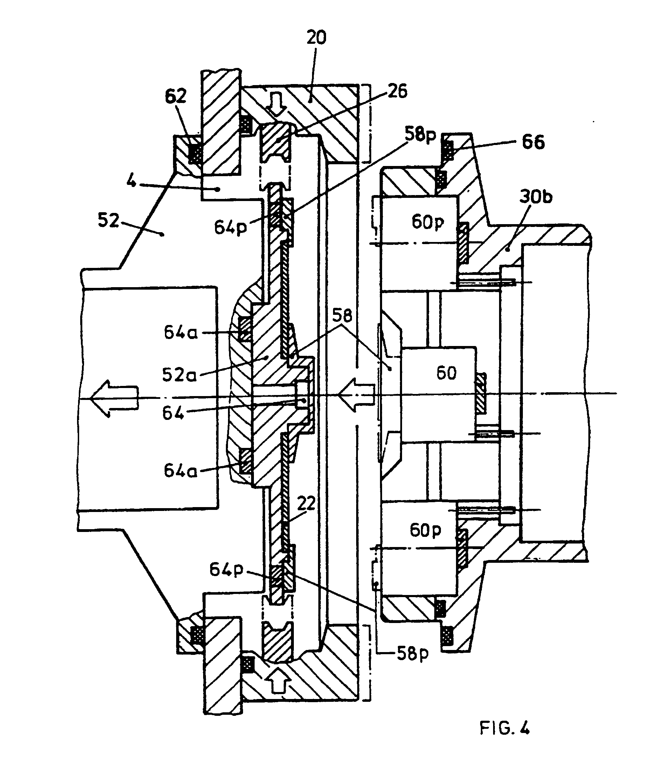

Wenn jeweils ein Arm 46 des Transportsternes 44 gegenüber einer Bearbeitungsstation bzw. der dazu führenden Oeffnung, wie 54, positioniert ist, wird sein Teller 52 vorgetrieben und legt sich beispielsweise und falls erforderlich, mit den Dichtungen 62 an die Umrandung der Oeffnung 54. Es erfolgtdie Oberflächenbearbeitung des maskierten Werkstückes 23, sei dies z.B. durch einen Aetzprozess oder einen Beschichtungsprozess. Am dargestellten Beispiel für Speicherplatten wird die periphere Maskierung durch einen Maskierungsring 72 ortsfest an der Bearbeitungsstation 56 montiert, realisiert, welcher federnd ausgebildet sein kann. Es ist jedoch ohne weiteres möglich, falls erforderlich, auch periphere oder andere Maskierungsorgane prinzipiell gleich wie das Zentral-Maskierungsorgan 58 zu handhaben, was noch anhand von Fig. 4 erläutert werden wird.

Wie bereits erwähnt, können auch an der Kammer 2 mehrere Bearbeitungsstationen vorgesehen sein und/oder gewisse der vorgesehenen Oeffnungen in weitere Transport- bzw. Verteilkammern ausmünden oder auch weitere Schleusenkammern. Wie schematisch bei 74 dargestellt, wird bei der dargestellten Anlage auch Kammer 2 für sich evakuiert bzw. konditioniert.

Die Steuerleitungen für den Antrieb der Teller 52 werden (nicht dargestellt) durch die Achse 50 des Sterns 44 geführt.

Wie in den Fig. 1 bis 2a nicht dargestellt, werden Maskierungsorgane 58 dann, wenn sie durch die Bearbeltung verbraucht sind, z.B. wenn nach mehreren Durchläufen deren Beschichtung zu dick geworden ist, nicht mehr in die Kammer 2 rückgeführt, sondern werden, z.B. mit dem Teller 30b, nicht mehr abgehoben und am bearbeiteten Werkstück verbleibend ausgeschleust. Da dies vorausgeplant ist, wird ein nicht bearbeitetes, mit der Aufnahme 20, wie oben beschrieben wurde, neu zugeführtes Werkstück, bereits mit einem Maskierungsorgan 58 in die Kammer 1 eingegeben, womit das ausgediente Maskierungsorgan 58 ersetzt wird.

Die vorliegende Erfindung wurde anhand eines bevorzugten speziellen Ausführungsbeispiels gemäss den Fig. 1 bis 2a dargestellt.

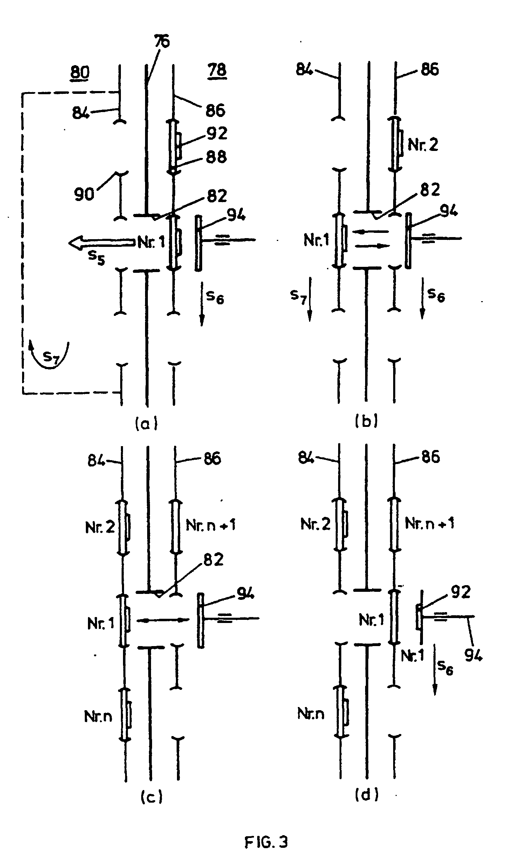

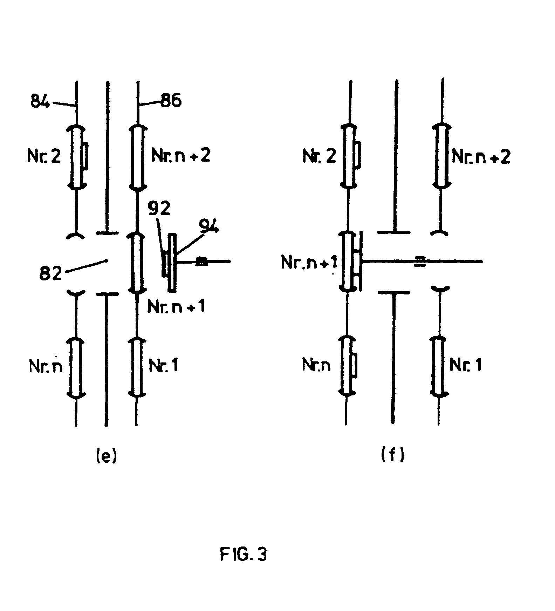

In Fig. 3 ist in prinzipieller Art dargestellt, wie grundsätzlich der Maskenwechsel zwischen zwei Transportorganen erfolgt, wenn dem diesbezüglichen Konzept gemäss den Figuren 1, 2, 2a gefolgt wird.

Gemäss Fig. 3a werden zwei Kammern 80 und 78 durch die Trennwand 76 mit Oeffnung 82 getrennt In jeder Kammer ist eine Transportvorrichtung angeordnet, hier schematisch als Bandförderer 84 bzw. 86 dargestellt. An jedem der Förderer sind steuerbare Festhalteorgane für die Werkstücke 88 vorgesehen, wie schematisch bei 90 dargestellt. Die Transportrichtung der Werkstücke 88 gegen die Bearbeitungsposition erfolgt von Kammer 78 in Kammer 80, wie durch s₅ dargestellt. Es werde nun die Anlage in Betrieb gesetzt.

Gemäss Fig. 3a ist dabei die Transportvorrichtung 84 leer, während mit der Transportvorrichtung 86 Werkstücke 88 gemeinsam mit den als separate Teile ausgebildeten Maskierungsorganen 92 in der mit s₆ angedeuteten Richtung zugeliefert werden. Das erste angelieferte Werkstück No. 1 wird über Oeffnung 82 gefördert und, wie in Fig. 3b dargestellt, mit dem Quertransportorgan 94, z.B. in Form eines Stössels, vom Förderer 86 durch Oeffnung 82 in Förderer 84 geschoben. Der Förderer 84 wird nun gemäss Fig. 3b in der beispielsweise eingetragenen Richtung s₇ weitergetaktet.

Dieser Vorgang läuft so lange, bis der zyklisch umlaufende Förderer 84 vollständig mit Werkstücken geladen ist, wovon ein Teil bereits bearbeitet ist Dabei war bis anhin Förderer 86 in Förderrichtung stromab der Oeffnung 82 immer geleert.

Am Förderer 84 seien n Werkstücke applizierbar. Nun erscheint nach seiner Bearbeitung, in Förderrichtung, stromab der Oeffnung 82, das Werkstück No. 1, wieder vor der Oeffnung 82 gemäss Fig. 3c. Das Werkstück No. (n+1) am Förderer 86 wird nun, ohne Maskierung 92, zugeliefert. Wie durch den Uebergang auf Fig. 3d ersichtlich, wird mit dem Quertransportorgan 94 einerseits das bearbeitete Werkstück No. 1 vom Förderer 84 in den Förderer 86 übergeführt und, andererseits, das Maskierungsorgan 92 vom Werkstück No. 1 abgehoben.

Daraufhin wird der Förderer 86 einen Schritt in Richtung s₆ weiter bewegt Damit entsteht die in Fig. 3e dargestellte Situation: Das bearbeitete Werkstück No. 1 wird zu einer Ausgabe aus Kammer 78 gefördert, während nun das Werkstück No. (n+1) über der Oeffnung 82 liegt. Mit dem Quertransportorgan 94 wird das Maskierungsorgan 92, welches bereits einen Umlauf von Oeffnung 82 zu Oeffnung 82 durch Kammer 76 durchlaufen hat, auf das unbearbeitete Werkstück No. (n+1) appliziert und dieses Werkstück, wie aus Fig. 3f hervorgeht, vom Förderer 86 durch Oeffnung 82 in Förderer 84 übergeführt

Damit ist am Förderer 86 die Werkstückaufnahme frei, womit sich nun die Zyklen gemäss Fig. 3(c) bis (f) wiederholen können.

In Fig. 4 ist anhand eines schematisch dargestellten Ausschnittes mit der Oeffnung 4 an derAnlage gemäss Fig. 1 eine weitere Ausbildung der Anlage dargestellt, bei der auch Peripher-Maskierungsorgane 58p, so wie das vorbeschriebene Maskierungsorgan 58, gewechselt werden. Der Teller 52 mit Dichtungen 62 trägt in der dargestellten Ausführungsforn, was nicht zwingend mit dem erwähnten Maskierungskonzept zu koppeln ist, eine Fahrzeugplatte 52a, welche magnetisch, vorzugsweise mittels Permanentmagneten 64a, am Teller 52, gehaltert ist.

Die Fahrzeugplatte 52a ihrerseits trägt teller- 52-seitig Periphermagnete 64ₚ sowie das zentrale Magnet 64. Eine Aufnahme 20 mit ihren Dichtungen wird, wie beschrieben wurde, durch Teller 30_{b} mit Dichtungen 66 gegen die Berandung der Oeffnung 4 getrieben. Am Teller 30_{b} sind Elektromagnete 60ₚ für das periphere Maskierungsorgan 58p bzw. 60 für das zentrale 58 vorgesehen. Mit den Magneten 60ₚ wird die Weitergabe des peripheren Maskierungsorgans 58p bewerkstelligt, in Analogie zu der vorbeschriebenen bezüglich des Maskierungsorgans 58.

Bei der Fahrzeugplatte 52a kann es sich um eine Werkstückadapterplatte handeln, welche jeweils entsprechend zu bearbeitenden Werkstücken 22 ausgewechselt wird. Sie durchläuft gemeinsam mit dem jeweiligen Werkstück 22 mindestens einen Teil der Werkstücktransportbahn. Wie schematisch dargestellt, greift der Festhaltemechanismus 26 bei Vorsehen der Fahrzeugplatte 52a an letzterer an.

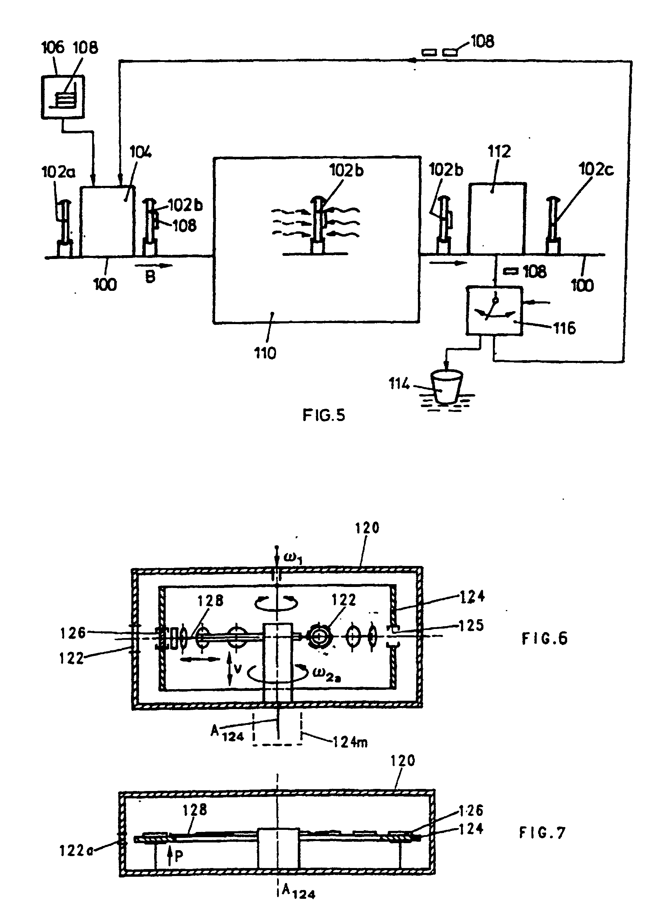

In Fig. 5 ist zum Aufzeigen der Allgemeinheit des beschriebenen Maskierungsverfahrens bzw. der Anlage hierfür dessen bzw. deren Grundprinzip dargestellt Auf einem Förderer 100 werden, wie schematisch dargestellt, Werkstücke 102a, ohne Maskierung, einer entlang des Förderers 100 und damit der Bewegungsbahn B der Werkstücke 102 wirkenden Applikationsstation 104 zugeführt, die von einem Magazin 106 mit losen Maskierungselementen 108 gespiesen wird. Ausgangsseitig der Applikationsstation 104, d.h. der Station, an der Maskierungselemente 108 den Werkstücken 102a aufgebracht werden, werden die nun mit dem Maskierungselement 108 versehenen Werkstücke 102b einer oder mehreren Bearbeitungsstationen zugeführt, generell dargestellt in Fig. 5 mit der Vakuumoberflächenbearbeitungsanordnung 110, worin die erwähnten Werkstücke 102b ein- oder zweiseitig oder rundum oberflächenbearbeitet werden. Ausgangsseitig der Anordnung 110 werden die nun bearbeiteten weiterhin maskierten Werkstücke 102b einer entlang der Bewegungsbahn B der Werkstücke wirkenden Entnahmestation 112 zugeführt und verlassen die Entnahmestation 112 als nun bearbeitete Werkstücke 102c, ohne Maskierungselement 108. Die an der Station 112 entfernten Maskier ungselemente 108 werden entweder an die Applikationsstation 104 rückgespiesen, oder, wenn sie nach mehreren Rückführungszyklen durch Wirkung der Bearbeitungsanordnung 110 verbraucht sind, wie bei 114 dargestellt, aus dem Umlauf gezogen. Dies über eine schematisch dargestellte gesteuerte Selektionseinheit 116.

Anhand der Fig. 6 und 7 soll das allgemein gültige Prinzip der Transporttechnik, wie sie an der bevorzugten Anlage gemäss den Fig. 1 bis 2a in der Kammer 1 realisiert ist, dargestellt werden.

Gemäss Fig. 6 ist in der Transportkammer 120, welche für sich und/oder durch mindestens eine der mindestens zwei vorgesehenen Kammeröffnungen 122 vakuumtechnisch konditionierbar ist, ein Karussell 124 vorgesehen, welches, wie bei ω₁ dargestellt, gesteuert drehgetrieben wird. Am Karussell sind, wie auch immer geartete, gegebenenfalls gesteuerte Festhalteorgane 125 für Werkstücke 126 vorgesehen.

Gemäss der Ausbildung nach Fig. 6 werden am Karussell 120 z.B. scheibenförmige Werkstücke 126 so gehaltert und transportiert, dass ihre Scheibenflächen bei Drehung um die Drehachse des Karussells 124 eine zylindrische Fläche aufspannen. Bezüglich der Drehachse A₁₂₄ des Karussells 124 in einer bevorzugten Variante drehfest radial gesteuert ausfahr- bzw. rückholbar, sind Schuborgane 128 vorgesehen. Sind sie drehfest, so ist ihre Anzahl gleich der Anzahl damit zu bedienender Oeffnungen 122 in der Kammer 120, welche Anzahl aber nicht zwingend gleich der Anzahl an der Kammer 120 überhaupt vorgesehener, von den Werkstükken durchlaufener Oeffnungen zu sein braucht.

Das Karussell 124 wird bevorzugterweise in Schritten drehgetrieben, so dass jeweils eine Aufnahme 125 auf eine zu bedienende Kammeröffnung 122 ausgerichtet wird, worauf mit dem besagter Kammeröffnung 122 fest zugeordneten Schuborgan 128 das positionierte Werkstück 126 in Richtung aus der Kammer 120 ausgegeben wird, oder, umgekehrt, durch besagte Oeffnung 122 ein Werkstück von ausserhalb der Kammer 120 rück- oder eingeholt wird.

Wie ersichtlich, können an einer solchen Transportkammer 120 in gezielt konditionierter Atmosphäre mehr Werkstücke 126 zwischengelagert werden als Schuborgane 128 vorgesehen sind. Es wird die Drehbewegung um die Achse 124 und die Radialbewegung, wie mit den Schuborganen 128 durchgeführt, getrennt, womit die Realisation der entsprechenden Antriebe und Steuerleitungen wesentlich vereinfacht wird.

Es ergibt sich eine optimale flache Kammer 120 aufgrund der Tatsache, dass sowohl die notwendige Drehbewegung des Karussells, wie auch die Radialbewegung der Schuborgane in einer Ebene erfolgen.

Letzteres ist allerdings nicht zwingend, sondern bevorzugt. Es ist durchaus möglich, die Schuborgane 128 zur Achse A₁₂₄ schief winklig anzuordnen, wie strich-punktiert in Fig. 6 angedeutet und, entsprechend, die Halterungen am Karussell sowie die Oeffnungen in der Kammer 120 vorzusehen. Im weiteren ist es auch möglich, an dem in Fig. 6 dargestellten Karussell, wie gestrichelt dargestellt, in Axialrichtung A₁₂₄ betrachtet, zwei oder mehr Lagen von Werkstücken vorzusehen und mittels in dieser Achsrichtung gestaffelter Schuborgane 128, Kammeröffnungen 122 zu bedienen oder gar, wie mit v dargestellt, die vorgesehenen Schuborgane 128 wohl weiterhin drehfest vorzusehen, aber in Axialrichtung gesteuert verschieblich. Wie in Fig. 6 mit ω₂ₐ dargestellt, ist es ohne weiteres möglich, auch die Schuborgane 128 um die Achse A₁₂₄ zu drehen, mit einem separaten Drehantrieb, wie gestrichelt bei 128ₘ dargestellt Wie dem Fachmann ersichtlich, ergibt sich eine Vielzahl von Möglichkeiten, das an der Kammer 120 bzw. 1 gemäss Fig. 1 - 2a realisierte Transportprinzip den jeweiligen Bedürfnissen entsprechend zu modifizieren.

Aus dieser Vielzahl sich nun eröffnender Möglichkeiten ist in Fig. 7 eine weitere dargestellt, die ermöglicht, die Transportkammer 120 in ihrer Bauhöhe wesentlich zu reduzieren. Das Karussell 124 ist hier so ausgebildet, dass die kleinste Werkstückdimension, bei deren Ausbildung als scheibenförmige Werkstücke 126 deren Dickenausdehnung, parallel zur Karussellachse 124 liegt. Analog, wie in Fig. 6, sind die Schuborgane 128 ausgebildet, und die vorgesehenen Oeffnungen 122a werden zu Schlitzen.

Es sei nun die Ausbildung der Kammer 2 in ihrer Allgemeinheit betrachtet, sowie das Konzept des Anlagenaufbaus, unter Verwendung jeweils mindestens einer Kammer nach dem Konzept von Kammer 1 bzw. von Kammer 2.

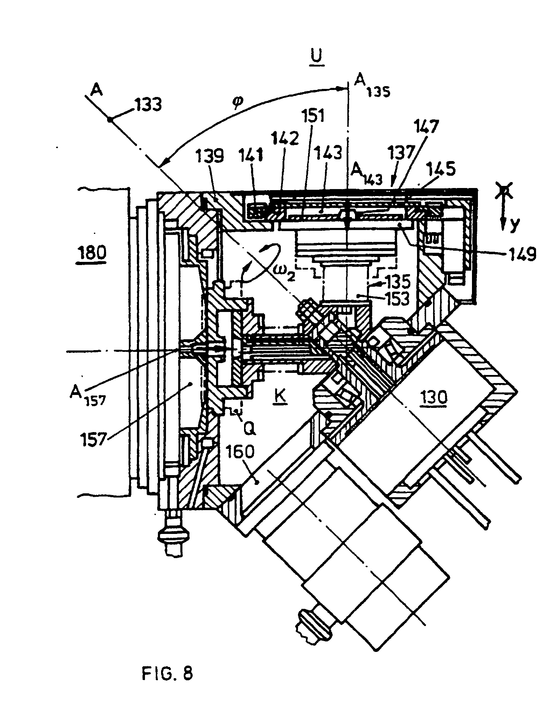

In Fig. 8 ist eine Querschnittsdarstellung einer weiteren Ausführungsvariante einer Kammer 2 gemäss den Fig. 1, 2 dargestellt. Sie umfasst einen Antriebsmotor 130, auf dessen Achse, als Raumachse A und physische Antriebsachse 133, mindestens ein Transportarm 135 mit einer Achse A₁₃₅ gewinkelt, beispielsweise um 45° zur Raumachse Agewinkelt, befestigt ist Wird mittels des Motors die Antriebsachse 133, wie bei ω₂ dargestellt, in Drehung versetzt, so überstreicht der oder die Transportarm(e) 135 eine Kegelfläche mit hier z.B. 45° Kegelöffnungswinkel ϕ. In Fig. 7 weist die Kammer K zwei zu bedienende Oeffnungen auf. Eine erste Oeffnung 137 ist beispielsweise und wie dargestellt, direkt als Schleusenöffnung ausgebildet Dann braucht eine, z.B. nach dem Prinzip der Kammer nach den Figuren 5, 6 aufgebaute weitere Kammer 180 gegebenenfalls keine Schleuse aufzuweisen. Sie umfasst einen Rahmen 139, daran angeflanscht einen auf- und abbeweglichen Rahmen 141. Innerhalb des getrieben auf- und abbeweglichen Rahmens 141 liegt ein Dichtrahmen 142, der das Schleusenvolumen 143 festlegt, mit einer Normalen A₁₄₃. Die Schleusenöffnung 137 umfasst weiter einen Deckel 145, welcher z.B. linear in Richtung x verschieblich ist. Er kann selbstverständlich auch um eine in Fig. 7 vertikale Achse zum Oeffnen und Schliessen schwenkbar sein. Er wird in seiner geschlossenen, dargestellten Position durch Absenken des Zwischenrahmens 141 in Richtung y, dichtend auf den Dichtrahmen 142 gelegt.

Damit wird die Schleusenöffnung 137 gegen die Umgebung U abgedichtet.

Der Transportarm 135 trägt, endständig, als Trägerpartie einen Teller 149, worauf ein zu behandelndes Werkstück, im dargestellten Beispiel eine Speicherscheibe 151, ruht. Wie gestrichelt dargestellt, kann am Transportarm 135 der Teller 149 von seinem Sitz (eingezeichnet) am Dichtrahmen 142 gegen die Raumachse A rückgeholt werden und damit die Schleuse transporteinrichtungsseitig geöffnet werden. Der Teller 149 braucht nicht dicht am Rahmen 142 anzuliegen, wenn in Kammer K nicht eine höchsten Reinheitsanforderungen genügende Atmosphäre aufrechterhalten werden muss. Das Werkstück 151 wird mit dem Transportarm durch Drehen der Welle 133 mittels des Motors 130 an die zweite dargestellte Oeffnung 157 gefördert. Der Radial-Antriebsmechanismus am Transportarm 135, dessen Ausbildung an sich die vorliegende Erfindung nicht tangiert und für welchen sich dem Fachmann manche Realisationsmöglichkeiten eröffnen, ist, was wesentlich ist, direkt an dem drehbaren Transportarm vorgesehen und mit einem Balg 153 vakuumdicht gegen die Umgebung in der Kammer K abgedichtet. Durch Drehen des Transportarmes 135 wird das Werkstück 151, nämlich die Scheibe, in den Bereich der zweiten Oeffnung 157 gefordert Die Oeffnung 157 legt die Oeffnungsflächennor male A₁₅₇ fest. Aus der gestrichelt dargestellten Annäherungsposition Q heraus wird der Transportteller 149 mit dem Werkstück 151 in die ausgezogen dargestellte Position mittels des erwähnten beispielsweise pneumatischen Hubmechanismus am Arm 135 wieder angehoben, so dass sich der Teller 149 nun dichtend an den Rand der Oeffnung 157 anlegt.

Gegenüber der Umgebung U ist die Kammer K vorzugsweise vakuumdicht aufgebaut Es werden je nach Einsatzzweck (nicht dargestellt), an den den Oeffnungen der Kammer K angekoppelten Stationen und/oder Transportkammern und/oder an der Kammer K selbst und/oder an der Schleusenöffnung 137, Einrichtungen vorgesehen, um gezielt jeweilige Atmosphären einzustellen, d.h. es werden daran Evakuierungsanschlüsse und/oder Gaseinlässe vorgesehen. Ein Pumpanschluss 160 für Kammer K und gegebenenfalls die Schleusenöffnung 137, sind in Fig. 8 dargestellt.

Ist die Kammer so ausgebildet, dass alle Kammeröffnungen durch je einen der vorgesehenen Arme 135 dichtend verschlossen werden, so ergibt sich damit die Möglichkeit,, die jeweiligen Atmosphären in den den Oeffnungen zugeordneten Bearbeitungsstationen und/oder Transportkammern und/oder Schleusenstationen, unabhängig von derjenigen in der Kammer K vorzugeben. In gewissen Fällen kann es aber durchaus genügen, eine gemeinsame Atmosphäre für mindestens eine weitere Kammer bzw. Station und die Kammer K vorzusehen, womit dann beispielsweise nur die Kammer K zu konditionieren bzw. zu evakuieren ist, wie in Fig. 8 z.B. dargestellt, gemeinsam z.B die Schleusenöffnung 135 und die Kammer K.

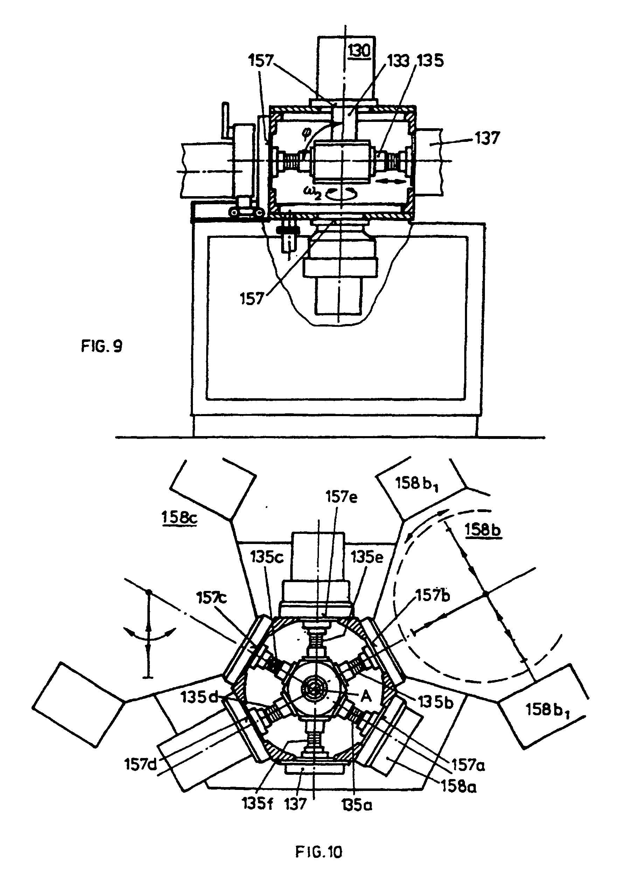

In Fig. 9 ist eine teilweise geschnittene Kammer, dem Prinzip von Kammer 2 in Fig. 1 - 2a folgend, dargestellt, bei der die Arme 135 von der Achse 133 des Motors 130 senkrecht ausragen, womit ϕ = 90° wird.

In Fig. 10 ist die Kammer, Teil einer Anlage in der Konfiguration gemäss Fig. 9, in Aufsicht dargestellt. Es bezeichnen gleiche Bezugszeichen die gleichen Bauelemente. Es sind um die Achse A z.B. sechs Transportarme 135a bis 135f angeordnet, analog wie in Fig. 9 ersichtlich und sie bedienen abwechselnd z.B. eine Schleusenstation 158a für die Ein- und Ausgabe von Scheiben 151 und eine Transportkammer 158b mit Stationen 158b₁, weitere fünf Kammern bzw. Bearbeitungsstationen durch Oeffnungen 157a bis 157e.

Die Oeffnung 157b ist z.B. einer Transportkammer 158b mit Karussell und Schuborganen, analog zur Kammer 1 bzw. den mit den Fig. 6 und 7 erläuterten, zugeordnet. Diese Kammer 158b ist mit weiteren Bearbeitungsstationen und/oder weiteren Transportstationen verbunden. Die Oeffnung 157c ihrerseits ist beispielsweise mit einer weiteren Kammer 158c des Typus gemäss Kammer 2 von Fig. 1 und wie sie weiter im Zusammenhang mit Fig. 8 erläutert wurde, verbunden, letztere wiederum mit weiteren Bearbeitungs- und/oder Transport- und/oder Schleusenkammern. Die dargestellte Konstellation der Gesamtanlage soll nur ein Beispiel dafür liefern, wie flexibel, modular, sowohl mit Kammern des Typs gemäss Kammer 1 von Fig. 1 - 2a und/oder des Typs gemäss Kammer 2 von Fig. 1 - 2a Anlagen zusammengestellt werden können. Es soll auf diese Flexibilität noch weiter eingegangen werden, wobei bereits in Fig. 10 die nachmals noch zu definierenden Kammertypsymbole verwendet sind.

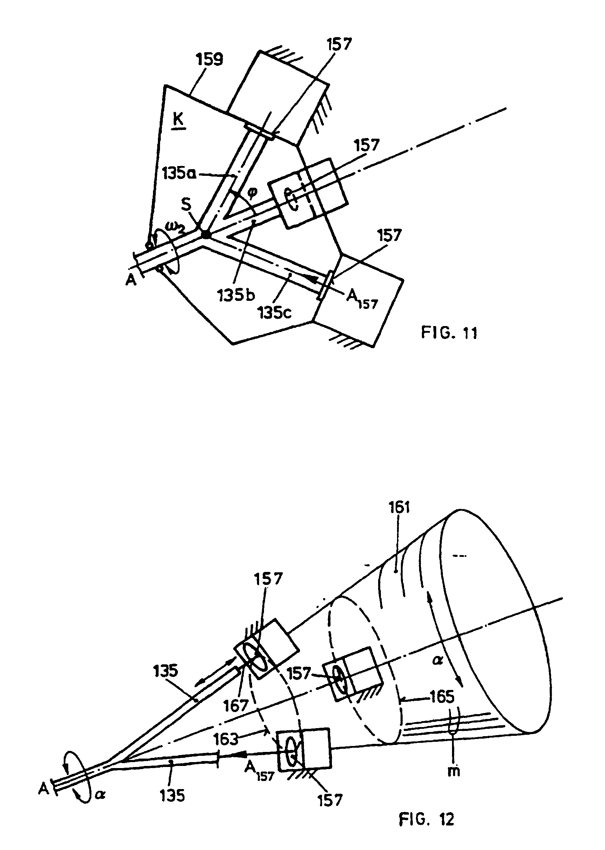

In Fig. 11 ist die anhand der Fig. 1, 2, 8 bis 10 erläuterte Kammer K weiter in ihrem Grundprinzip schematisch dargestellt. Mit den z.B. drei hier dargestellten Transportarmen 135a bis 135c, um die Raumachse A drehend, werden, beispielsweise, die eingetragenen drei Oeffnungen 157 bedient. Mit der Begrenzung 159, schematisch eingetragen, ist die Kammer K umrandet. Die Transporteinrichtung überstreicht bei ihrer Drehung ω₂ eine Kegelfläche mit Oeffnungswinkel ϕ und bedient die Oeffnungen 157, welche die Flächennormalen 157 festlegen. Letztere sind in Richtung von Mantellinien des überstrichenen Kegels gerichtet. Es liegen die Oeffnungen 157 auf einem Grosskreis der überstrichenen Kegelfläche, d.h. sie sind alle von der Spitze S des durch die Arme 135 überstrichenen Kegels, gleich weit entfernt.

In Fig. 12 ist eine weitere Möglichkeit dargestellt. Hier liegen auf dem dargestellten, von den Armen 135 überstrichenen Kegel 161 Oeffnungen auf dem einen Grosskreis 163 und weitere, wovon nur eine eingetragen ist, auf dem Grosskreis 165. Die Oeffnungsflächennormalen A₁₅₇ weisen wiederum in Richtung der Ke-gelmantellinien m. Um die Oeffnungen 157, welche auf unterschiedlichen Grosskreisen 163, 165 liegen, zu bedienen, sind die Arme 135, wie bei 167 schematisch dargestellt, getrieben verlängerbar bzw. verkürzbar, wie über einen pneumatischen Teleskopantrieb, z.B. abgedeckt mit hier nicht dargestelltem Balg, analog zum Balg 153 von Fig. 8. Damit wird es möglich, Oeffnungen 157 nicht nur auf einem Grosskreis, wie bei der Kammer gemäss den Fig. 8 bis 10 anzuordnen, sondern, vorzugsweise azimutal, ϕ, versetzt, auf mehreren Kegelgrosskreisen.

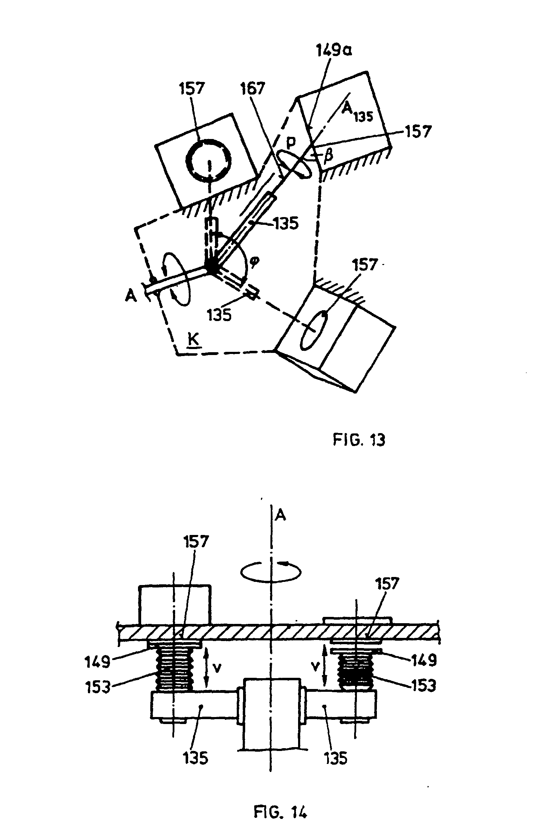

Bei einer Weiterbildung der Kammer K nach Fig. 13 sind die Arme 135, wie wiederum bei 167 dargestellt, auch ausfahrbar bzw. rückholbar und tragen eine Transportplatte 149a. Zusätzlich ist der Kegelwinkel ϕ getrieben einstellbar, so dass Kegel mit unterschiedlichen Oeffnungswinkeln ϕ überstrichen werden können. Mithin können in weiten Grenzen beliebig angeordnete Oeffnungen 157 bedient werden. Es ist zudem die Trägerplatte 149a gewinkelt in einem Winkel β ≦ 90° am jeweiligen Arm 135 gelagert und, wie bei p dargestellt, um die Armachse A₁₃₅ drehbar. Sowohl die Kegelwinkeleinstellung ϕ, wie auch das Einfahren und Ausfahren des Armes, wie auch die Drehung bei p werden gesteuert getrieben vorgenommen, womit es mit einer solchen Anordnung möglich ist, räumlich praktisch beliebig angeordnete Oeffnungen 157 zu bedienen. Gestrichelt ist wiederum die Begrenzung der Kammer K dargestellt.

Gemäss Fig. 14 sind die Arme 135 so L-förmig ausgebildet und gelagert, dass sie parallel zur Drehachse A liegen. Liegt die Raum- bzw. Drehachse A vertikal, so hat dies den wesentlichen Vorteil, dass mithin Werkstücke auf den Tellern 149 nicht gehaltert zu werden brauchen. Die Antriebe für die Bewegung v der Teller 149 liegen innerhalb der Bälge 153.

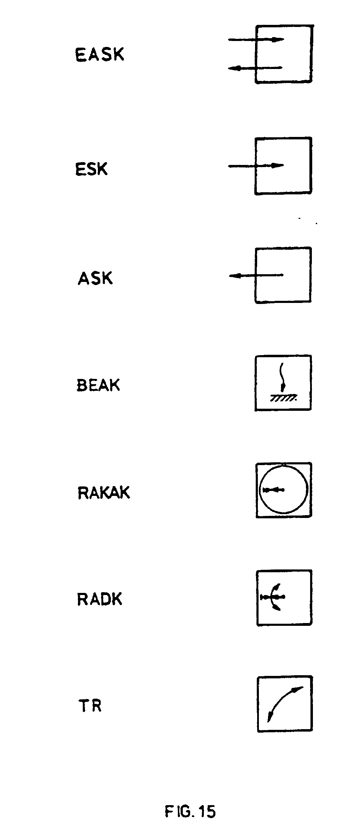

Es seien nun folgende Kammertypen definiert und, zur graphischen Vereinfachung, in Fig. 15 mit den hier definierten Abkürzungen, zeichnerische Symbole:

### 1. Ein- und Ausgabe-Schleusenkammer (EASK)

Eine Schleusenkammer, womit Werkstücke in beiden Richtungen durchgeschleust werden.

### 2. Eingangsschleusenkammer (ESK)

Eine Schleusenkammer, an der Werkstücke nur in Richtung gegen ihre Vakuumoberflächenbehandlung eingeschleust werden.

### 3. Ausgangsschleusenkammer (ASK)

Eine Schleusenkammer, mittels welcher Werkstücke nur in Richtung von der Vakuumoberflächenbehandlung durchtransportiert werden.

### 4. Bearbeitungskammer (BEAK)

Eine Kammer, worin Werkstücke oberflächenbearbeitet werden, wie abgetragen, beschichtet, gereinigt, erhitzt, gekühlt etc.

### 5. Radial bediente Karussellkammer (RAKAK)

Eine Transportkammer des Typs, wie sie anhand bzw. durch Kammer 1 in den Fig. 1 und 2 sowie in den Fig. 6, 7 dargestellt und erläutert wurde.

### 6. Radial bediente Drehsternkammern (RADK)

Eine Kammer des Typs der Kammer 2 von Fig. 1 und, wie sie weiter im Zusammenhang mit den Fig. 8 bis 14 dargestellt und erläutert wurde.

### 7. Transportkammer (TR)

Eine Kammer, worin Werkstücke zwischen mindestens zwei Oeffnungen verschoben werden, womit die Kammern EASK, ESK, ASK, RAKAK und RADK davon umfasst sind, aber insbesondere auch Kammern mit anderen Transportmechanismen als die mit Bezug auf die Kammern RAKAK und RADK gezeigten und beschriebenen.

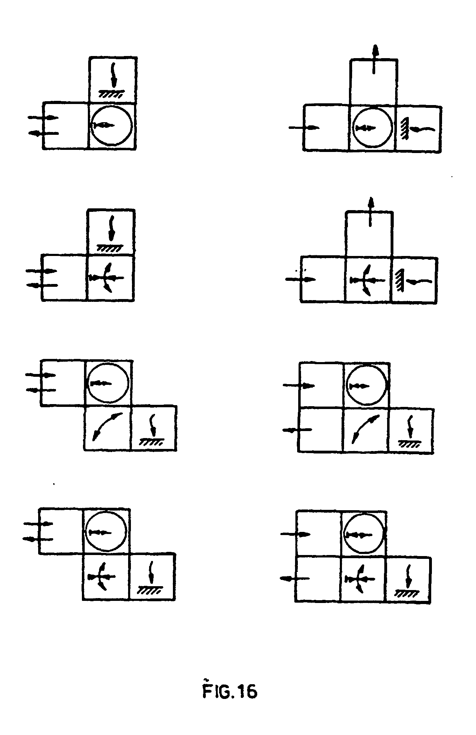

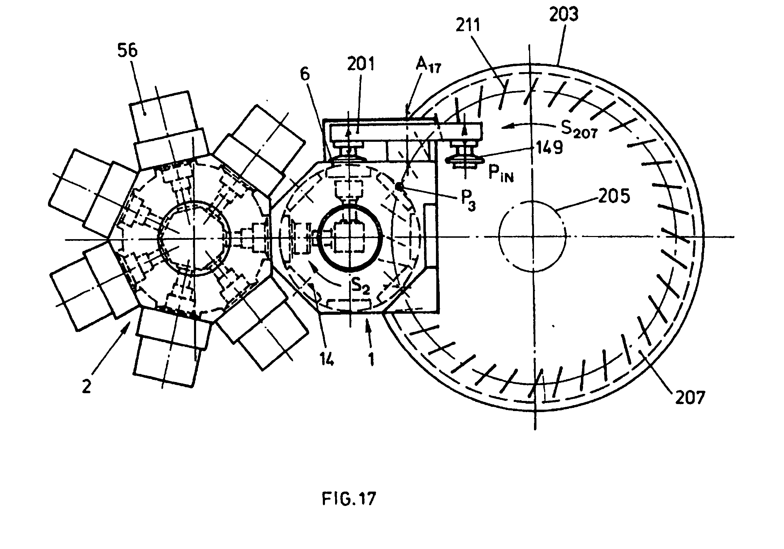

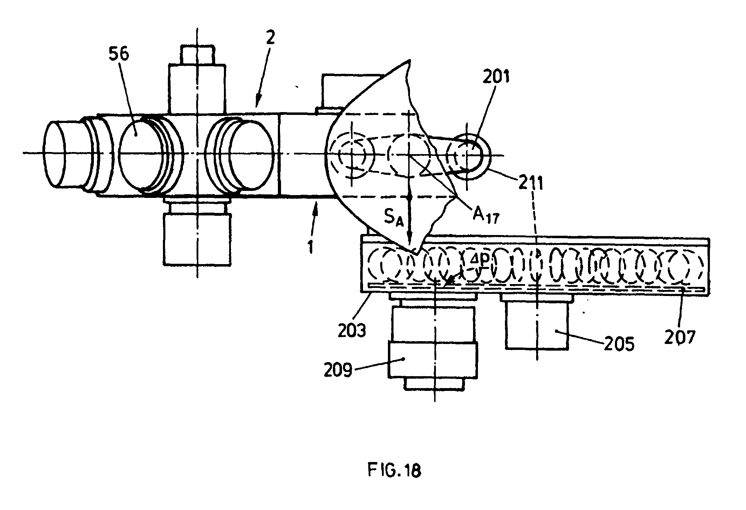

In Fig. 16 sind einige Konfigurationen von Anlagen dargestellt, worin mindestens eine der Kammern eine RAKAK- oder RADK-Kammer ist. Daraus ist ersichtlich, dass sich mit den beiden Kammertypen sowie weiteren bekannten Kammern in höchster Flexibilität, modular beliebige Anlagenkonfigurationen zusammenstellen lassen mit oder ohne Mitintegration des Maskierungskonzeptes gemäss Fig. 5. Das erfindungsgemässe Vorgehen eignet sich insbesondere für die Bearbeitung von magneto-optischen Speicherplatten.

In den Fig. 17 und 18 ist, jeweils in Aufsicht und in Seitenansicht, schematisch, eine weitere bevorzugte Anlagekonfiguration dargestellt. Sie umfasst die Kammer 2, wie sie insbesondere anhand der Fig. 1 und 2 erläutert wurde, sowie die ebenfalls dort beschriebene Kammer 1. Die Oeffnung 6 der Kammer 1, insbesondere aus Fig. 2 ersichtlich, wird durch einen Drehroboterarm 201, analog zu dem in Fig. 14 dargestellten, bedient und ist, um Achse A₁₇, getrieben drehbeweglich. Mittels der axial vor- und rückholbaren Teller 149 werden die scheibenförmigen Substrate in der Position P_{IN}, wie schematisch dargestellt, aufgenommen und durch Drehen des Roboterarmes 201 in die Position an der Oeffnung 6 gebracht. Dort werden sie, wie bereits anhand von Fig. 2 beschrieben wurde, in die Kammer 1 übernommen. Daraufhin dreht das Karussell 14 in Richtung S₂ um ein Drehwinkelinkrement weiter. Das eben eingeführte, scheibenförmige Substrat liegt im Karussell in Position P₃.

Wie insbesondere aus Fig. 18 ersichtlich, ist unterhalb der Kammer 1 eine Entgasungskammer 203 angeordnet, welche einen durch einen zentrischen Antrieb 205 getriebenen Transportdrehteller 207 umfasst. Die Entgasungskammer 203 wird separat von einer Vakuumpumpe 209 gepumpt. In Position P₃ des Substrates gemäss Fig. 17 wird letzteres in Richtung S_{A} gemäss Fig. 18 durch einen nicht dargestellten Transportschieber von der oberen Position in Kammer 1 in die darunterliegende in der Entgasungskammer 203 transportiert. Während das Karussell 14 in Kammer 1 weiterhin stationär bleibt, wird mit dem Antrieb 205 der Transportteller 207 in Kammer 203 in der in Fig. 17 mit S₂₀₇ angegebenen Richtung um ein Winkelinkrement weitergedreht. Dadurch kommt eines der Substrate 211 in die Position unterhalb P₃ zu liegen, welches in der Kammer 203 einen vollständigen Umlauf vollzogen hat.

Mit dem erwähnten Transportschieber wird nun das letzterwähnte Substrat in Richtung S_{A} von der Kammer 203 in Position P₃ in Kammer 1 hochgehoben und nimmt am Karussell 14 denjenigen Platz ein, der eben von einem der Kammer 203 neu zugeführten Substrat belegt war. Daraufhin wird das Karussell 14 in Kammer 1 um ein Drehwinkelinkrement in Richtung S₂ weitergedreht.

Es ist nun ohne weiteres ersichtlich, dass alle Substrate ab der Position P₃ in der Kammer 1 diese Kammer verlassen und während einer langen Zeit in der Entgasungskammer 203 entgast werden, was durch Vorsehen beispielsweise zusätzlicher Heizelemente in dieser Kammer 203 (nicht dargestellt) unterstützt werden kann, bis sie an der erwähnten Position P₃ zurück in Kammer 1 aufgenommen werden und ihrer Bearbeitung zugeführt werden. Dabei wird der Arbeitstakt der Gesamtanlage aber nicht verlangsamt. Von der Kammer 1 werden die Werkstücke, wie beschrieben wurde anhand von Fig. 1 und 2, der Kammer 2 übergeben und dort mittels der beispielsweise sechs dargestellten Bearbeitungsstationen 56 bearbeitet. Durch die Dimension der Entgasungskammer bzw. ihrer Aufnahmekapazität kann die notwendige Entgasungszeit für die jeweilige Anwendung leicht vorgegeben werden.

Während der Uebergabe der scheibenförmigen Werkstükke, Substrate 211, von Kammer 1 in Entgasungskammer 203 kann mit Hilfe des erwähnten Transportschiebers eine jeweilig schleusenartige Abtrennung von Kammer 1 zu Kammer 203 sichergestellt werden. Die Vakuumpumpe 209 stellt sicher, dass Entgasungsprodukte aus der Kammer 203 entfernt werden. Durch sie wird ein Druckgradient in der Kammer 203 hin zur Pumpe 209 sichergestellt, wie gestrichelt bei Δp in Fig. 18 dargestellt.

## Patentansprüche

1. Verfahren zur Fertigung vakuumbehandelter Speicherplatten aus Kunststoff, bei dem die Speicherplatten mittels eines Maskierungsorgans aus magnetischem Material maskiert einer Vakuumbehandlung unterzogen werden, dabei mittels eines Magneten (64) an einem Werkstückträgerteller (52) an diesem gehalten werden, **dadurch gekennzeichnet, dass** das Maskierungsorgan elektromagnetisch (60) an das Werkstück und den Magneten (64) übergeben wird und das Werkstück durch Magnet und Maskierungsorgan am Werkstückträgerteller (52) gehalten, in Vakuum, zur Vakuumbehandlung transportiert wird.

2. Verfahren nach Anspruch 1, **dadurch gekennzeichnet, dass** man am Werkstückträgerteller das Werkstück dadurch auswechselt, dass man das Maskierungsorgan entfernt, das eine Werkstück durch ein anderes ersetzt und das Maskierungsorgan am anderen Werkstück wieder anbringt.

3. Transportanordnung für mindestens ein scheibenförmiges Werkstück in Vakuum mit einem Teller (52) zur Aufnahme des Werkstückes, das eine Halteanordnung am Teller (52) für das Werkstück, ein Maskierungsorgan (58) aus magnetischem Material und am Teller (52) einen Magneten (64) aufweist, **dadurch gekennzeichnet, dass** der Teller an einer Transportvorrichtung angebracht ist und in einer gegebenen Position des Tellers (52), ihm gegenüberliegend, ein Elektromagnet (60) vorhanden ist, mittels welchem das Maskierungsorgan (58) an Werkstück und Magnet (64) am Teller (52) angelegt wird.

4. Anordnung nach Anspruch 3, **dadurch gekennzeichnet, dass** das Elektromagnet an einer weiteren Transportvorrichtung montiert ist.

5. Anordnung nach Anspruch 4, **dadurch gekennzeichnet, dass** die Transportvorrichtung und/oder die weitere Transportvorrichtung durch einen Transportrotor gebildet ist bzw. sind, welche je um eine Drehachse drehbar getrieben sind.

6. Anordnung nach einem der Ansprüche 3 bis 5, **dadurch gekennzeichnet, dass** die Transportvorrichtung in einer Vakuumkammer montiert ist und die Bewegungsbahn des Magneten an mindestens einer Öffnung der Vakuumkammer vorbeiführt und dass der Elektromagnet im Bereiche der genannten Öffnung mit dem Maskierungsorgan in diesem Bereiche in Wirkverbindung steht.

7. Anordnung nach Anspruch 6, **dadurch gekennzeichnet, dass** der Elektromagnet an einer weiteren Transportvorrichtung montiert ist ausserhalb der Vakuumkammer und die Bewegungsbahn des Elektromagneten an der Öffnung vorbeiführt.

8. Anordnung nach Anspruch 7, **dadurch gekennzeichnet, dass** die weitere Transportvorrichtung ein getrieben um eine Achse drehbeweglicher Transportrotor ist.

9. Anordnung nach einem der Ansprüche 6 bis 8, **dadurch gekennzeichnet, dass** der Magnet an der Transportvorrichtung an einem getrieben gegen bzw. von der Öffnung beweglichen Träger montiert ist.

10. Anordnung nach Anspruch 9, **dadurch gekennzeichnet, dass** der Träger die Öffnung schliessend, vorzugsweise dichtend schliessend, gegen die Öffnung bewegbar ist.

11. Anordnung nach Anspruch 10, **dadurch gekennzeichnet, dass** ausserhalb der Kammer eine weitere Transportvorrichtung vorgesehen ist mit einem Werkstückträger, welcher an der Öffnung getrieben vorbeibewegbar ist und, mit ihr in Ausrichtung gebracht, gegen die Öffnung hin bzw. von der Öffnung weg getrieben beweglich ist, und dass der Werkstückträger und der Träger Schleusenventile einer durch die Öffnung gebildeten Schleusenkammer sind.

12. Anordnung nach einem der Ansprüche 3 bis 11, **dadurch gekennzeichnet, dass** das Maskierungsorgan Maskierungsorgan für mindestens eine durch die Transportanordnung bediente Werkstückoberflächen-Behandlungsstation ist.

## Claims

1. Process for the production of vacuum-treated memory boards of plastic, in which the memory boards masked by a masking element of magnetic material are subject to vacuum treatment, held by means of a magnet (64) on a workpiece carrier plate (52), **characterised in that** the masking element is applied electromagnetically (60) to the workpiece and the magnet (64), and the workpiece held by the magnet and masking element on the workpiece carrier plate (52) in a vacuum is transported for vacuum treatment.

2. Process according to claim 1, **characterised in that** on the workpiece carrier plate the workpieces are exchanged **in that** the masking element is removed, the one workpiece replaced by another and the masking element attached again to the next workpiece.

3. Transport arrangement for at least one disc-like workpiece in a vacuum with a plate (52) for holding the workpiece, which has a holder arrangement on the plate (52) for the workpiece, a masking element (58) of magnetic material and on the plate (52) a magnet (64), **characterised in that** the plate is bought to a transport device and in a given position of the plate (52) opposite thereof there is provided an electromagnet (60) by means of which the masking element (58) is applied to the workpiece and magnet (64) on the plate (52).

4. Arrangement according to claim 3, **characterised in that** the electromagnet is mounted on a further transport device.

5. Arrangement according to claim 4, **characterised in that** the transport device and/or the further transport device is/are formed by a transport rotor which is driven rotatable about an axis of rotation.

6. Arrangement according to any of claims 3 to 5, **characterised in that** the transport device is mounted in a vacuum chamber and the movement path of the magnet passes at least one opening of the vacuum chamber and that the electromagnet in the area of the said opening is operatively connected to the masking element in this area.

7. Arrangement according to claim 6, **characterised in that** the electromagnet is mounted on a further transport device outside the vacuum chamber and the movement path of the electromagnet passes the opening.

8. Arrangement according to claim 7, **characterised in that** the further transport device is a transport rotor driven rotationally mobile about an axis.

9. Arrangement according to any of claims 6 to 8, **characterised in that** the magnet on the transport device is mounted on a carrier drivingly movable to or from the opening.

10. Arrangement according to claim 9, **characterised in that** the carrier can be moved towards the opening, thereby closing the opening, preferably sealingly.

11. Arrangement according to claim 10, **characterised in that** outside the chamber is provided a further transport device with a workpiece carrier which is drivingly movable past the opening and, brought into alignment with this, can be drivingly moved towards the opening or away from the opening, and that the workpiece carrier and the carrier form lock valves of a lock chamber formed by the opening.

12. Arrangement according to any of claims 3 to 11, **characterised in that** the masking element is a masking element for at least one workpiece surface treatment station served by the transport device.

## Revendications

1. Procédé pour fabriquer des disques numériques en matière plastique traités sous vide, selon lequel les disques sont soumis à un traitement sous vide en étant masqués à l'aide d'un organe de masquage en matériau magnétique et en étant retenus sur un plateau porte-pièce (52) grâce à un aimant (64) prévu sur celui-ci, **caractérisé en ce que** l'organe de masquage est transféré par voie électromagnétique (60) sur la pièce et sur l'aimant (64), et la pièce est transportée vers le traitement sous vide en étant retenue sur le plateau porte-pièce (52) grâce à l'aimant et à l'organe de masquage, sous vide.

2. Procédé selon la revendication 1, **caractérisé en ce que** sur le plateau porte-pièce, on change la pièce en enlevant l'organe de masquage, en remplaçant une pièce par une autre et en remettant l'organe de masquage sur l'autre pièce.

3. Dispositif de transport pour au moins une pièce en forme de plaque sous vide avec un plateau (52) pour recevoir la pièce, comportant un dispositif de fixation sur le plateau (52) pour la pièce, un organe de masquage (58) en matériau magnétique et, sur le plateau (52), un aimant (64), **caractérisé en ce que** le plateau est monté sur un mécanisme de transport, et dans une position donnée du plateau (52), il est prévu en face de celui-ci un électro-aimant (60) à l'aide duquel l'organe de masquage (58) est appliqué sur la pièce et sur l'aimant (64) prévu sur le plateau (52).

4. Dispositif selon la revendication 3, **caractérisé en ce que** l'électro-aimant est monté sur un mécanisme de transport supplémentaire.

5. Dispositif selon la revendication 4, **caractérisé en ce que** le mécanisme de transport et/ou le mécanisme de transport supplémentaire sont formés par un rotor de transport qui sont entraînés pour pouvoir tourner chacun autour d'un axe de rotation.

6. Dispositif selon l'une des revendications 3 à 5, **caractérisé en ce que** le mécanisme de transport est monté dans une chambre à vide et la trajectoire de l'aimant passe devant au moins une ouverture de ladite chambre à vide, et **en ce que** l'électro-aimant commandé est en relation fonctionnelle, dans la zone de cette ouverture, avec l'organe de masquage dans cette zone.

7. Dispositif selon la revendication 6, **caractérisé en ce que** l'électro-aimant est monté sur un mécanisme de transport supplémentaire, à l'extérieur de la chambre à vide, et sa trajectoire passe devant l'ouverture.

8. Dispositif selon la revendication 7, **caractérisé en ce que** le mécanisme de transport supplémentaire est constitué par un rotor de transport mobile en rotation autour d'un axe.

9. Dispositif selon l'une des revendications 6 à 8, **caractérisé en ce que** l'aimant est monté sur le mécanisme de transport sur un support qui est apte à être déplacé vers l'ouverture et à partir de celle-ci.

10. Dispositif selon la revendication 9, **caractérisé en ce que** le support est apte à être déplacé vers l'ouverture en fermant celle-ci, de préférence de manière étanche.

11. Dispositif selon la revendication 10, **caractérisé en ce qu'**un mécanisme de transport supplémentaire est prévu à l'extérieur de la chambre, avec un porte-pièce qui est apte à être entraîné pour passer devant l'ouverture et, une fois aligné sur celle-ci, à être déplacé vers l'ouverture et à partir de celle-ci, et **en ce que** le porte-pièce et le support sont constitués par des vannes d'une chambre formant sas définie par l'ouverture.

12. Dispositif selon l'une des revendications 3 à 11, **caractérisé en ce que** l'organe de masquage est constitué par un organe de masquage pour au moins une station de traitement de surface des pièces qui est desservie par le dispositif de transport.
